# EUROPEAN PATENT APPLICATION

(11) **EP 4 687 390 A1**
(43) Date of publication of application: **04.02.2026**
(21) Application number: 25193077.2
(22) Date of filing: 31.07.2025
(51) Int. Cl.: H05K 7/20

(54) **COOLING SYSTEM FOR AN ELECTRIC DEVICE FOR A VEHICLE**

(30) Priority: 01.08.2024 IT 202400018010
(71) Applicant: IVECO S.P.A., 10156 Torino (IT)
(72) Inventor: RUSSO, Gerardo, 10156 TORINO (IT)
(74) Representative: Studio Torta S.p.A.

(57) **Abstract**

An assembly comprising a cooling system for an electric device (1), comprising a box (2) adapted to define a space (3) adapted to house the electric device (1) and a mechanical connection (4) for mechanically connecting the electric device (1) to said box (2), the cooling system comprising a fluid (5) housed in a sealed manner in the space (3) of the box (2) so as to surround the electric device (1), this assembly further comprising a thermally conductive mass (M), at least one of the walls of the box (2) being connected to said mass (M).

## Description

### CROSS-REFERENCE TO RELATED APPLICATIONS

This patent application claims priority from Italian patent application no. 102024000018010 filed on August 1, 2024, the entire disclosure of which is incorporated herein by reference.

### TECHNICAL SECTOR

This invention relates to a cooling system for an electric device.

This invention has its preferred, though not exclusive, application in cooling an electric device for vehicle uses. This application will be referred to below by way of example.

### PRIOR ART

There is an ever greater need to use at least partially electric vehicles in order to reduce vehicle consumption and, thus, environmental emissions.

At least partially electric vehicles use, as known, electric machines that exchange electricity, in use or being generated, with energy storage means, such as battery packs.

The electricity passing through the above-mentioned elements, and in relation to other elements that use or produce it in the vehicle, is channelled by electric devices, such as, for example, inverters or PDUs (power distribution units) .

These electric devices are placed inside protective housings, usually metal boxes, and fixed to them using appropriate fasteners. The inside of these protective boxes is normally empty, i.e. a space housing air.

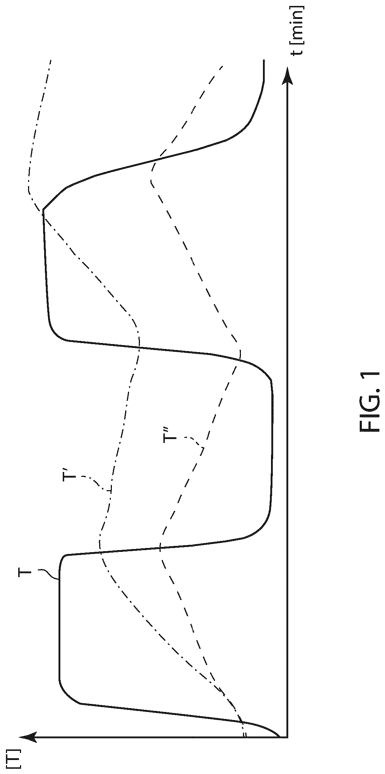

These elements managing the flow of electricity between the various vehicle elements tend to heat up as illustrated by way of example in Figure 1.

Figure 1 illustrates the temperature of the electric device as a function of time in relation to an operation curve T of the same. Usually, the above-mentioned electric devices may be exemplified by an ON-OFF curve or "square wave" representing the alternation between operating state and switched-off state.

As illustrated by the T' curve, the free air cooling of the electric devices in their housing is not enough since the temperature T' tends to continuously increase at each activation cycle of the electric device.

Thus, it is known to provide conditioning systems configured to actively cool the electric device, for example using forced ventilation or actual heat exchangers that are part of the refrigerant cycle conditioning systems.

Clearly, these active conditioning systems require power to be able to operate, reducing the overall efficiency of the vehicle.

In addition, active conditioning systems are bulky and, thus, reduce the vehicle's useful space, making it difficult to assemble and house other vehicle elements.

Again, the above-mentioned active conditioning systems often require maintenance, which entail vehicle stoppages that further increase the vehicle operating costs.

There is, thus, a need to cool electric devices for the vehicle in an efficient, compact, and cost-effective manner.

The purpose of this invention is to meet the needs outlined above in an optimal and inexpensive way.

### SUMMARY OF THE INVENTION

The above-mentioned purpose is achieved with a cooling system as claimed in the attached claims, which are an integral part of this description.

### BRIEF DESCRIPTION OF THE DRAWINGS

For a better understanding of this invention, a preferred embodiment is described below by way of non-limiting example and with reference to the accompanying drawings, wherein:
- Figure 1 is a diagram illustrating the change in temperature as a function of time of an electric device during its operation;
- Figure 2 illustrates a schematic embodiment of an electric device comprising a cooling system according to the invention in a first assembly configuration; and
- Figure 3 illustrates a schematic embodiment of an electric device comprising a cooling system according to the invention in a second assembly configuration.

### DETAILED DESCRIPTION OF THE INVENTION

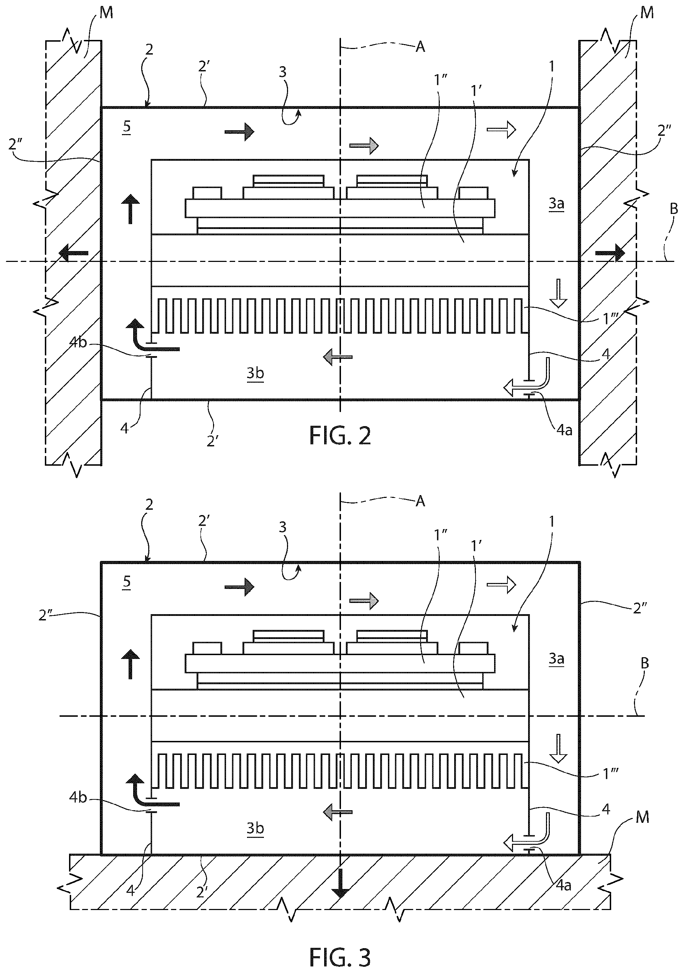

Figure 2 illustrates an assembly, for example a vehicle, comprising an electric device 1, such as an inverter, a DC/DC converter, or a PDU (power distribution unit), used, for example, in a vehicle system (not illustrated).

The electric device 1 is housed in a container 2 defining a space 3 for housing, advantageously insulated from the outside.

The device 1 is connected to the container 2 via at least one mechanical connection 4, such as, for example, connecting rods, elastic connections, welding, or connections housing electric cables/busbars as in the example illustrated in Figure 3, thus also providing an electrical connection outside the container 2.

In particular, a passive fluid conditioning system using a fluid 5 contained within the space 3 that is sealed off from the external environment is provided.

Advantageously, this fluid is ambient air. However, the use of other, possibly electrically insulating and thermally conductive fluids may be envisaged.

The pressure of the air or another gas is, advantageously, the ambient pressure. However, the use of air or another gas at a different pressure, advantageously higher than ambient pressure, may be envisaged in order to increase heat exchange.

In the embodiments in Figures 2 and 3, the container 2 is schematically illustrated comprising a pair of first walls 2' facing each other and spaced apart along a first axis A, or longitudinal axis, and a pair of second walls 2'' facing each other and spaced apart along a second axis B, or vertical axis, advantageously perpendicular to the first axis A.

The first and second pair of walls 2', 2'' are connected together to define the space 3. In any case, it is clearly possible that the box 3 is made of one or more elements connected together and of different shapes and types compared to what is illustrated.

In particular, the mechanical connection is formed using a box-shaped element 4 fixed to the container 2 and dividing the space 3 into two portions, a first portion 3a outside the box-shaped element and a second portion 3b inside the box-shaped element 4.

The box-shaped element 4 also defines a first opening 4a and a second opening 4b configured to enable fluidic communication between the first and second portion 3a, 3b of the space 3.

More specifically, the box-shaped element 4 comprises a pair of first walls 4' facing each other along the direction of the first axis A and a second wall 4'' extending transversely to the pair of first walls 4' and advantageously perpendicular to these.

The first and second openings 4a, 4b are preferably formed in the pair of first walls 4', one for each wall 4', while the electric device 1 is placed between the first pair of walls, via mechanical friction coupling, above the first and second openings 4a, 4b, i.e. along the direction of the second axis B.

Specifically, the pair of first walls 4' is fixed to one of the second pair of walls 2'', for example the lower one along the direction of the second axis B. The pair of first walls 4' is also spaced apart along the direction of the first axis A in relation to the first walls 2' of the box 2 and the second wall 4'' is spaced apart in relation to the wall 2'' opposite the one for fastening the first walls 4' so as to create a channel between the openings 4a, 4b.

In more detail, the electric device 1 comprises a support portion 1' that carries an electronic processing portion 1'' on one side and a dissipation portion 1‴ on the opposite side to the first side. At least the dissipation portion 1‴ is wet by the fluid 5.

In the embodiment described, the support portion 1' is housed via friction and hermetically sealed inside the box-shaped element 4 keeping the electronic processing portion 1'' insulated from the fluid 5, i.e. facing the second wall 2", and the dissipation portion 1''' submerged in the fluid 5.

As known, the dissipation portion 1‴ comprises a profile, for example finned, configured to ease the exchange of heat with the outside to dissipate the heat generated by the electronic processing portion 1" that passes via the support portion 1'.

Specifically, at least one of either the first or second pair of walls 2', 2" is rigidly connected to a thermally conductive body M, acting as a heat sink. Consequently, this thermally conductive body must have sufficient mass and thermal inertia to allow the passage of heat from the aforementioned first and/or second wall 2', 2".

At least one of said walls 2', 2" is, advantageously, entirely in contact with the body M. This fastening may be achieved by the interposition of thermally conductive material.

Figures 2 and 3 illustrate two assembly configurations for the box 2 as shown above.

In Figure 2, the first pair of walls 2' is in contact with the body M, as illustrated both walls 2' are entirely in contact with that body M.

In Figure 3, one of the second pair of walls 2' is in contact with the body M, specifically the lower wall.

The operation of the embodiment of the cooling system according to the invention described above is the following.

Referring to the particular operation of the embodiment in Figures 2 and 3, cooling is realised as the mechanical element 4 defines a passage channel for the fluid 5, via the two openings 4a, 4b, with the box 2. In this configuration, the heat transmitted by the dissipation means 1''' heats the fluid 5 that tends to leave the opening 4b, circulate around the walls 4', 4", cooling down and returning from the opening 4a near the dissipation means 1‴. The recirculation of the fluid 5 described above, makes it possible to increase the dissipation of the heat of the electric device 1, making the transfer of heat to the body M effective and possible.

Essentially, according to the embodiment described, as illustrated in the graph in Figure 1, the fluid 5 makes it possible to cool the electric device 1. Thus, in the inactivity phase of the operation curve T of the electric device 1, the air lets heat disperse more rapidly (T" curve), thus maintaining the temperature of the electric device 1 below a pre-determined safety threshold temperature.

The advantages of a cooling system for an electric device according to the invention are clear from the foregoing.

Thanks to the cooling system described, it is possible to effectively, cost-effectively, and compactly cool an electronic device, thus solving the issues related to the prior art systems.

In particular, it is possible to make the electric devices operate at greater frequencies, without having to forcibly increase the dimensions of the housing box or provide active conditioning systems.

In particular, the system is basically applicable, without additional bulk and with a reduced increase in weight, to any type of electric device without needing to change its fastening nor its arrangement.

In particular, thanks to the described embodiments that couple a particular box arrangement with a dissipating mass, it is possible to obtain a substantial heat dissipation capacity from the fluid, thus providing a particularly effective cooling system.

Lastly, it is clear that modifications and variations may be made to the cooling system for an electric device according to this invention, without, however, departing from the scope of protection defined by the claims.

Clearly, as demonstrated, the mechanical coupling 4 and the electric device 1 can be made with any shape and type suitable for this purpose.

As mentioned, the fluid can be of various chemical compositions as long as it is thermally conductive and electrically insulating.

Again, the electric device can be of any kind using electricity, such as a pure electric, electronic, or electromechanical device, such as an electric machine.

## Claims

1. An assembly comprising an electric device (1) and a cooling system for said electric device (1), said cooling system comprising a box (2) adapted to define a space (3) adapted to house said electric device (1) and a mechanical connection (4) for mechanically connecting said electric device (1) to said box (2), said cooling system comprising a fluid (5) housed in a sealed manner in said space (3) of said box (2) so as to surround, at least partially, said electric device (1), said fluid being thermally conductive and electrically insulating,
said assembly further comprising a thermally conductive mass (M), at least one of the walls of said box (2) being connected to said mass (M).

2. The assembly according to claim 1, wherein said electric device (1) comprises a support portion (1'), an electronic processing portion (1") carried by one side of said support portion (1') and a dissipation portion (1‴) carried by the opposite side of said support portion (1') with respect to said electronic processing portion (1"), at least said dissipation portion (1‴) being surrounded by said fluid (5).

3. The assembly according to claim 2, wherein said support portion (1") is carried directly by said box (2), said mechanical connection (4) being a contact connection between first walls (2') of said box (2) and said support portion (1"), said space (3) being divided by the coupling of said support portion (1") and said walls (2') into a first and a second portion (3', 3"), said second portion (3") being placed above the first (3') and housing said fluid (5), said dissipation portion (1") being housed in said second portion (3").

4. The assembly according to claim 3, wherein said mechanical connection (4) comprises a boxed element comprising a pair of first walls (4') and a second wall (4") extending transversely between said pair of first walls (4'), said support portion (1') being carried between said first walls (4') and said electronic processing portion (1") facing said second wall (1"), said space (3) being comprised between said boxed element and said box (2) being occupied by said fluid (5).

5. The assembly according to claim 4, wherein between said first walls (4') and said second wall (4") and said box (2) a channel (3a, 3b) is defined which allows the circulation of said fluid (5) around said boxed element.

6. The assembly according to claim 5, wherein said first walls (4') each define an opening (4a, 4b) configured to allow the passage of said fluid between an external portion (3a) of said box and an internal portion (3b) of said box.

7. The assembly according to claim 6, wherein said openings (4a, 4b) are placed at different heights.

8. The assembly according to one of the preceding claims, wherein said fluid (5) is a gas.

9. The assembly according to claim 8, wherein said gas is ambient air.

10. A system according to claim 8 or 9, wherein said fluid (5) is at a pressure different from the ambient pressure.

11. A vehicle comprising an assembly according to one of the preceding claims and defining said mass (M) of said assembly.

12. A vehicle according to claim 11, wherein said at least one of said walls of said box (2) being entirely in contact with said mass (M).
